Europäisches Patentamt

European Patent Office

Office européen des brevets

(19)

(11) Veröffentlichungsnummer : **0 252 309 B1**

(12) # EUROPÄISCHE PATENTSCHRIFT

(45) Veröffentlichungstag der Patentschrift :
15.05.91 Patentblatt 91/20

(51) Int. Cl.$^5$ : **G01R 31/36**

(21) Anmeldenummer : 87108220.2

(22) Anmeldetag : 06.06.87

(54) Entladezustandsanzeige für eine Batterie.

(30) Priorität : 09.07.86 DE 3622991

(43) Veröffentlichungstag der Anmeldung :
13.01.88 Patentblatt 88/02

(45) Bekanntmachung des Hinweises auf die
Patenterteilung :
15.05.91 Patentblatt 91/20

(84) Benannte Vertragsstaaten :
AT DE GB NL

(56) Entgegenhaltungen :
DE-C- 1 186 542
PATENT ABSTRACTS OF JAPAN, Band 5, Nr.
167 (E-79)[839], 24. Oktober 1981; & JP - A - 56
096 534 (MATSUSHITA DENKO) 04.08.1981

(73) Patentinhaber : Braun Aktiengesellschaft
Rüsselsheimer Strasse 22
W-6000 Frankfurt/Main (DE)

(72) Erfinder : Lang, Gerhard
Merzhäuser Strasse 26
W-6395 Altweilnau (DE)

## Beschreibung

Die Erfindung betrifft eine Entladezustandsanzeige für eine Batterie mit einer Drossel und einem ersten Transistor in Serie zur Batterie, wobei die Basis des ersten Transistors periodisch angesteuert wird, mit einem von der Batterie gespeisten Verbraucher und mit einer parallel zur Kollektor-Emitter-Strecke des ersten Transistors geschalteten Anzeigevorrichtung.

Solche Anordnungen werden angewandt, wenn die Anzeigevorrichtung eine höhere Betriebsspannung benötigt als die Batteriespannung. Ist die Energiequelle beispielsweise eine einzellige Batterie und die Anzeigevorrichtung eine Leuchtdiode, muß die Batteriespannung auf etwa zwei Volt angehoben werden. Solche Anordnungen werden auch als Gleichspannungs-Hochsteller oder Aufwärts-Schaltregler bezeichnet.

Ein solcher Aufwärtsschaltregler ist beispielsweise aus Elektronik, Heft 26/85 vom 27.12.1985, Seiten 57 bis 59 bekannt. Bei dem dort gezeigten Aufwärtsschaltregler erfolgt das Ansteuern des Schalttransistors mittels eines Schaltreglers, der einen Oszillator enthält, das heißt der Schalttransistors bzw. die ganze Anordnung ist fremdgesteuert.

Aufgabe der Erfindung ist es, eine Entladezustandsanzeige für eine Batterie zu schaffen, die sich durch einen geringen Bauteileaufwand sowie gute Funktionssicherheit und einfache Handhabung auszeichnet.

Diese Aufgabe wird dadurch gelöst, daß bei einer Entladezustandsanzeige der eingangs genannten Art die im kennzeichnenden Teil des Patentanspruchs 1 angegebenen Maßnahmen durchgeführt werden.

Der Vorteil dieser Lösung besteht außerdem darin, daß die Messung der Batteriespannung automatisch bei Betriebslast erfolgt, ohne daß eine Batterieprüftaste erforderlich ist. Der Benutzer erkennt rechtzeitig, wann die Batterie wieder aufgeladen werden muß, um einen ungestörten Betrieb seines Geräts zu gewährleisten. Da die Anordnung selbst schwingt, ist keine Fremdsteuerung nötig. Sie zeichnet sich deshalb durch einen einfachen Aufbau und geringe Herstellungskosten aus. Die Stromaufnahme für die Anzeige, wann die Batterie nachgeladen oder ersetzt werden muß, ist gering. Die Schaltung schwingt erst an und die Anzeigevorrichtung spricht erst dann an, wenn die eingestellte Schwelle der Batteriespannung unterschritten wird. Durch das Hystereseverhalten der Anordnung erfolgt kein Flackern der Leuchtanzeigevorrichtung im Bereich der eingestellten Schwelle.

Vorteilhafte Ausgestaltungen sind den Unteransprüchen entnehmbar, wobei deren Vorteile zusammen mit in der nun folgenden Beschreibung zweier Ausführungsbeispiele näher erläutert sind.

Fig. 1 zeigt eine einfache Ausführungsform der erfindungsgemäßen Entladezustandsanzeige,

Fig. 2 zeigt ein Ausführungsbeispiel, das weitere vorteilhafte Ausgestaltungen für einen induktiven Verbraucher, beispielsweise einen Gleichstrommotor, enthält.

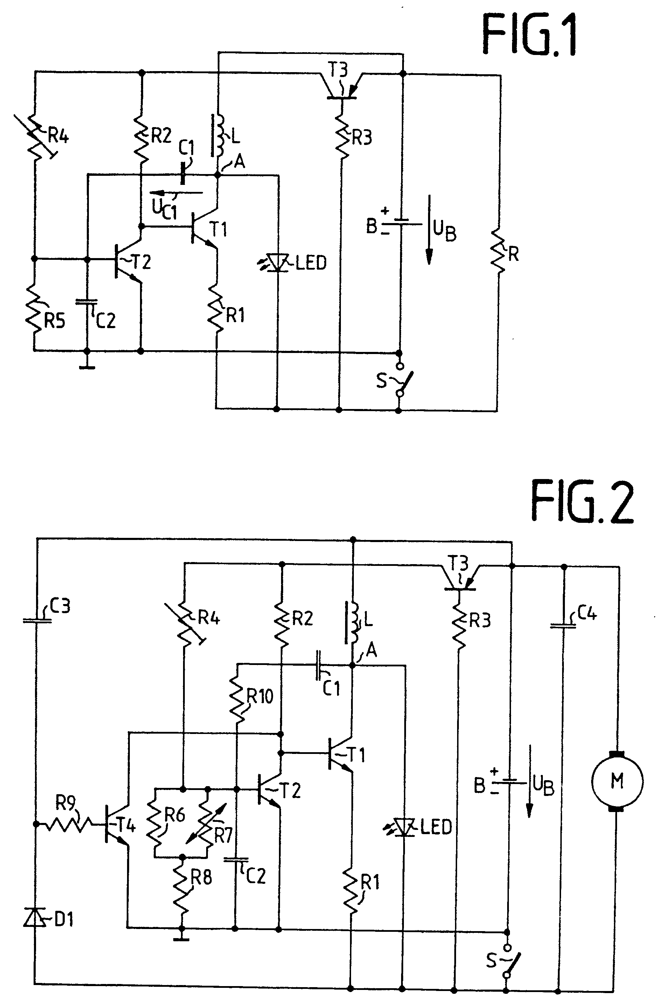

In Fig. 1 ist die Energiequelle beispielsweise eine einzellige Batterie, welche die Spannung UB abgibt. Der Minuspol der Batterie B stellt hier das Bezugspotential dar. Über einen Ein/Ausschalter S wird ein Verbraucher, der hier den Widerstand R darstellt, angeschlossen. Gleichzeitig wird bei geschlossenem Schalter S in Serie zur Batterie B und dem Schalter S eine Drossel L, ein erster Transistor T1, der den Schalttransistor darstellt, und ein Emitter-Widerstand R1 an die Batteriespannung angelegt. Parallel zum Transistor T1 und zum Emitter-Widerstand R1 liegt eine Leuchtdiode LED. Der Verbindungspunkt der Drossel L mit dem Transistor T1 und der Anode der Leuchtdiode LED ist mit A gekennzeichnet. An den Pluspol der Batterie B ist die Emitter-Kollektor-Strecke eines dritten Transistors T3 in Serie zu einem Widerstand R2 und zu einem zweiten Transistor T2 an Minuspotential der Batterie B geschaltet. Parallel zu dem Widerstand R2 und dem Transistor T2 liegt ein Spannungsteiler R4/R5, an dessen Verbindungspunkt die Basis des Transistors T2 angeschlossen ist. Die Basis des Transistors T3 ist über einen Widerstand R3 an das der Batterie abgewandte Ende des Schalters S angeschlossen.

Diese Anordnung hat den Vorteil, daß zusammen mit dem Ein- und Ausschalter S, der den Verbraucher an die Batterie anlegt, erst die Anordnung in Betrieb gesetzt wird und daß die Erfassung der Batteriespannung direkt an den Polen der Batterie erfolgt, so daß der Übergangswiderstand des Scharters S diese Erfassung nicht verfälschen kann. Der Spannungsteiler aus der Widerständen R4, R5 ist so eingestellt, daß der Transistor T2 erst sperrt, wenn eine bestimmte Batteriespannung UB unterschritten wird, die beispielsweise 20% unter der Nennspannung liegen kann. Diese gewünschte Ansprechschwelle, ab welcher die Leuchtdiode LED anzeiger soll, wird mittels des Widerstandes R4 eingestellt.

Im folgenden soll nun die Wirkungsweise dieser Anordnung erläutert werden.

Als Ausgangspunkt dieser Betrachtung wird angenommen, daß der Schalter S offen ist, also keine Spannung an der Schaltungsanordnung und am Verbraucher R anliegt und die Drossel L und der Kondensator C1 entladen sind, Wird nun der Schalter S geschlossen, das heißt die Batterie B bzw. die Batteriespannung UB an den Verbraucher R angelegt, wird gleichzeitig auch der Stromkreis, der aus der Drossel L, dem Transistor T1, dem Emitterwiderstand R1 und der Leuchtdiode LED besteht, an die Batterie B angeschlossen und die übrigen Schaltungsteile (Widerstand R2, Transistor T2, Spannungsteiler R4/R5) werden mittels des nun durchgeschalteten Transistors T3 aktiviert. Die Batteriespannung UB wird durch den Spannungsteiler R4/R5 direkt, das heißt ohne Einfluß des sich möglicherweise ändernden Übergangswiderstands des Schalters S, im Betriebszustand erfaßt. Liegt die Batteriespannung UB über der mittels R4 eingestellten Schwelle, ist der Transistor T2 leitend und der Transistor T1 bleibt gesperrt. Die Leuchtdiode LED bleibt dunkel, da deren Durchbruchsspannung höher ist als die über die Drossel L angelegte Batteriespannung UB.

Sinkt nun die Batteriespannung UB unter die eingestellte Schwelle, die beispielsweise 20% unter der Nennspannung der Batterie liegen kann, beginnt der Transistor T2 zu sperren und der Transistor T1 schaltet, über den Widerstand R2 angesteuert, durch. Der Kondensator C1 wird über den Widerstand R4 und die Kollektor-Emitter-Strecke des Transistors T1 auf der linken Elektrode positiv vorgeladen.

Über den durchgeschalteten Transistor T1 beginnt durch die Drossel L ein linear ansteigender Strom zu fließen, wodurch die am Emitterwiderstand R1 abfallenden Spannung steigt. Dadurch gelangt jetzt auf die rechte Elektrode des Kondensators C1 eine gegenüber der linken Elektrode positive Spannung und der jetzt umgekehrt fließende Ladestrom hebt das Basispotential des Transistors T2 an, so daß dieser leitend wird und den Transistor T1 sperrt. Die in der Drossel L aufgebaute Induktionsspannung, die der kurz zuvor angelegten Spannung entgegengesetzt ist, addiert sich zu der Batteriespannung UB. Im Moment des Sperrens des Transistors T1 geht die Spannung am Punkt A auf den Wert UDF hoch, wobei UDF die Durchflußspannung der Leuchtdiode LED ist.

Infolge der Spannungserhöhung am Punkt A steigt die Spannung UC1 am Kondensator C1 nochmals an, wodurch infolge des Ladestroms der Transistor T2 voll aufgesteuert bleibt und der Transistor T1 voll gesperrt bleibt. Der durch die Leuchtdiode LED fließende Strom nimmt infolge der abfallenden Induktionsspannung der Drossel L ab und die Spannung UC1 am Kondensator C1 sinkt, wodurch der Ladestromeinfluß des Kondensators C1 auf die Basis des Transistors T2 nachläßt. Die Basis-Emitter-Strecke des Transistors T2 wird nun wieder von dem Spannungsteiler R4/R5 bestimmt und der Transistor T2 beginnt aufgrund der entsprechend eingestellten Schwelle zu sperren. Hierdurch wird der Transistor T1 wieder leitend und der Vorgang wiederholt sich, wie oben beschrieben. Das bedeutet, daß die Anordnung zu schwingen und damit die Leuchtdiode LED zu leuchten beginnt, sobald die Batteriespannung UB bei eingeschaltetem Verbraucher R unter den vorgegebenen Wert sinkt.

Die Anordnung ist also selbstschwingend und es sind keine Bauteile für eine Fremdsteuerung der Basis des Transistors T1 notwendig. Die Schwingfrequenz richtet sich nach der Belastung durch die Leuchtdiode LED und nach der Dimensionierung der Drossel L und des Kondensators C1. Bei einem praktischen Ausführungsbeispiel mit einer einzelligen Batterie B und einer Leuchtdiode LED mit einer Durchbruchsspannung von 2 Volt beträgt die Schwingfrequenz ca. 280 kHz.

Der parallel zur Basis-Emitter-Strecke des Transistors T2 geschaltete Kondensator C2 vergrößert die Sperrzeit des Transistors T2 und damit die Aufmagnetisierungszeit der Drossel L, wodurch die Induktionsspannung der Drossel L steigt und die Leuchtdiode LED heller leuchtet.

Die Funktionsweise der in Fig. 2 dargestellten Anordnung ist dieselbe wie die in Fig. 1. Sich entsprechende Bauteile sind gleich gekennzeichnet. Der Verbraucher ist hier ein Gleichstrommotor M, dem ein Glättungskondensator C4 parallel geschaltet ist.

Der untere Spannungsteilerwiderstand (R5 in Fig. 1) besteht hier aus den parallel geschalteten Widerständen R6, R7 und dem dazu in Serie geschalteten Widerstand R8, wobei der Widerstand R7 als NTC-Widerstand (Widerstand mit negativem Temperaturkoeffizient) ausgebildet ist. Diese Widerstandsanordnung dient zur Anpassung an den Temperaturgang der Batterie, wobei für diese Anordnung die Art des Verbrauchers natürlich keine Rolle spielt.

Der hier in Fig. 2 zusätzlich in Reihe zum Kondenstaor C1 geschaltete Widerstand R10 dient zur Dämpfung der auftretenden Störspannungsspitzen, insbesondere der vom Motor M herrührenden Störspannungsspitzen.

Die weiters in Fig. 2 vorgesehenen Ausgestaltungen (Transistor T4, Widerstand R9, Kondensator C3, Diode D1) dienen zur Verbesserung der Funktionsweise beim Ein- und Ausschalten der Anordnung bei einem Gleichstrommotor M als Verbraucher, das heißt bei einem Verbraucher mit induktivem Verhalten. Hierbei ist die Kollektor-Emitter-Strecke eines Transistors T4 parallel zur Kollektor-Emitter-Strecke des Transistors T2 geschaltet. An den Motor M ist die Serienschaltung eines Kondensators C3 und einer Diode D1 angeschlossen. Der Verbindungspunkt des Kondensators C3 mit der Kathode der Diode D1 ist über einen Widerstand R9 an die Basis des Transistors T4 geführt.

Beim Schließen des Schalters S wird durch den Anlaufstrom des Motors M die Batterie B stärker belastet und die Batteriespannung UB sinkt kurzzeitig unter die eingestellte Ansprechschwelle, was ein Aufleuchten der Leuchtdiode LED zur Folge hätte, auch wenn die Batterie noch genügend geladen ist. Über den Kondensator C3 und den Widerstand R9, welche ein Zeitglied darstellen, wird nun beim Einschalten der Transistor T4 sofort angesteuert, wodurch die Basis des Transistors T1 auf Bezugspotential gelegt und somit ein Anschwingen der Schaltung verhindert wird. Der Kondensator C3 entlädt sich über den Widerstand R9 und die durchgeschaltete Basis-Emitter-Strecke des Transistors T4. Die Zeitkonstante C3, R9 bestimmt, wie lange der Transistor T4 durchgeschaltet bleibt, das heißt wie lange nach dem Einschaltzeitpunkt die Anordnung stillgesetzt bleibt.

Beim Ausschalten des Motors bleibt dieser nicht sofort stehen, sondern läuft noch einige Zeit nach und wirkt als Generator, der kurzzeitig die Schaltung speist, was ebenfalls ein Aufleuchten der Leuchtdiode LED zur Folge hätte. Dies wird dadurch verhindert, daß beim Öffnen des Schalters S der Transistor T4 kurzzeitig leitend wird, womit die Basis des Transistors T1 ebenfalls kurzzeitig auf Bezugspotential gelegt und somit ein Schwingen der Schaltung verhindert wird.

## Ansprüche

1. Entladezustandsanzeige für eine Batterie (B) mit einer Drossel (L) und einem ersten Transistor (T1) in Serie zur Batterie, wobei die Basis des ersten Transistors (T1) periodisch angesteuert wird, mit einem von der Batterie (B) gespeisten Verbraucher (R, M) und mit einer parallel zur Kollektor-Emitter-Strecke des ersten Transistors (T1) geschalteten Anzeigevorrichtung (LED), dadurch gekennzeichnet,

a) daß zwischen der Basis des ersten Transistors (T1) und dem einen Pol (–) der Batterie (B) ein zweiter Transistor (T2) angeordnet ist, dessen Basis so vorgespannt ist und mittels eines ersten Kondensators (C1) in Abhängigkeit von dem durch die Drossel (L) fließenden Strom so beeinflußt ist, daß die Anordnung beim Absinken der Batteriespannung (UB) unter einen festgelegten Wert zu schwingen beginnt und damit die Anzeigevorrichtung (LED) anspricht,

b) daß an dem einen Pol (–) der Batterie (B), hinter dem Anschlußpunkt der Hauptstromstrecke des zweiten Transistors (T2), ein Schalter (S) vorgesehen ist, der

b1) den Strom durch den Verbraucher (R, M) einschaltet,

b2) den Strom durch die Drossel (L) einschaltet und

b3) durch die Ansteuerung eines dritten Transistors (T3), der zwischen dem anderen Pol (+) der Batterie (B) und der Hauptstromstrecke des zweiten Transistors (T2) liegt, die Anordnung in Betrieb setzt.

2. Entladezustandsanzeige nach Anspruch 1, dadurch gekennzeichnet, daß über die Hauptstromstrecke des dritten Transistors (T3) die Basis des zweiten Transistors (T2) mittels eines parallel zur Batterie (B) angeordneten Spannungsteilers (R4, R5) vorgespannt ist und die Basis des ersten Transistors (T1) über einen ersten Widerstand (R2) mit dem anderen Pol (+) der Batterie (B) in Verbindung steht und daß der erste Kondensator (C1) zwischen der Basis des zweiten Transistors (T2) und dem Verbindungspunkt (A) der Drossel (L) mit dem ersten Transistor (T1) angeordnet ist.

3. Entladezustandsanzeige nach Anspruch 1 oder 2, dadurch gekennzeichnet, daß parallel zur Basis-Emitter-Strecke des zweiten Transistors (T2) ein zweiter Kondensator (C2) geschaltet ist.

4. Entladezustandsanzeige nach einem der vorhergehenden Ansprüche, dadurch gekennzeichnet, daß in Reihe zu dem ersten Kondensator (C1) ein zweiter Widerstand (R10) in Reihe geschaltet ist.

5. Entladezustandsanzeige nach einem der vorhergehenden Ansprüche, dadurch gekennzeichnet, daß der Basiswiderstand (R5) des zweiten Transistors (T2) aus der Serienschaltung zweier parallel geschalteter Widerstände (R6, R7) und eines dritten Widerstands (R8) besteht, wobei einer der parallel geschalteten Widerstände (R7) als NTC-Widerstand zur Anpassung an den Temperaturgang der Batterie (B) ausgebildet ist.

6. Entladezustandsanzeige nach einem der vorhergehenden Ansprüche, wobei der Verbraucher eine induktive Last, beispielsweise ein Motor (M), ist, dadurch gekennzeichnet, daß parallel zur Kollektor-Emitter-Strecke des zweiten Transistors (T2) ein vierter Transistor (T4) geschaltet ist, dessen Basis über einen vierten Widerstand (R9) an den Verbindungspunkt eines dritten Kondensators (C3) und einer Diode (D1), die in Serie an den Verbraucher angeschlossen sind, geschaltet ist.

7. Entladezustandsanzeige nach einem der vorhergehenden Ansprüche, dadurch gekennzeichnet, daß die Anzeigevorrichtung eine Leuchtdiode (LED) ist.

## Claims

1. A discharge indicating means for a storage battery (B), with a choke (L) and a first transistor (T1) connected in series with the storage battery, with the base of the first transistor (T1) being periodically controlled, with a load (R, M) energized by the storage battery (B), and with an indicating device (LED) connected in parallel with the collector-emitter circuit of the first transistor (T1), characterized in that

(a) a second transistor (T2) is arranged between the base of the first transistor (T1) and the one pole (negative pole) of the storage battery (B), the base of said second transistor being biased and influenced by means of a first capacitor (C1) in dependence on the current flowing through the choke (L), such that the arrangement starts oscillating when the battery voltage (UB) falls below a predetermined value, causing the indicating device (LED) to respond,

(b) a switching device (S) is provided at the one pole (negative pole) of the storage battery (B) subsequent to the junction of the main circuit of the second transistor (T2), said switching device

    (b1) establishing the current through the load (R, M),

    (b2) establishing the current through the choke (L), and

    (b3) by the control of a third transistor (T3) arranged between the other pole (positive pole) of the storage battery (B) and the main circuit of the second transistor (T2), putting the arrangement into operation.

2. A discharge indicating means as claimed in claim 1, <u>characterized in that</u>, via the main circuit of the third transistor (T3), the base of the second transistor (T2) is biased by means of a voltage divider (R4, R5) connected in parallel with the storage battery (B) and the base of the first transistor (T1) is connected to the other pole (positive pole) of the storage battery (B) through a first resistor (R2), and that the first capacitor (C1) is arranged between the base of the second transistor (T2) and the junction (A) of the choke (L) and the first transistor (T1).

3. A discharge indicating means as claimed in claim 1 or claim 2, <u>characterized in that</u> a second capacitor (C2) is connected in parallel with the base-emitter circuit of the second transistor (T2).

4. A discharge indicating means as claimed in any one of the preceding claims, <u>characterized in that a</u> second resistor (R10) is connected in series with the first capacitor (C1).

5. A discharge indicating means as claimed in any one of the preceding claims, <u>characterized in that the</u> base resistor (R5) of the second transistor (T2) is composed of two resistors (R6, R7) in parallel arrangement and a third resistor (R8) connected in series therewith, with one of the paralleled resistors (R7) being configured as an NTC resistor serving for adaptation to the temperature variation of the storage battery (B).

6. A discharge indicating means as claimed in any one of the preceding claims, in which the load is an inductive load as, for example, a motor (M), <u>charac-terized in that</u> a fourth transistor (T4) is connected in parallel with the collector-emitter circuit of the second transistor (T2), the base of said fourth transistor being connected through a fourth resistor (R9) to the junction of a third capacitor (C3) and a diode (D1) which are connected in series with the load.

7. A discharge indicating means as claimed in any one of the preceding claims, <u>characterized in that</u> the indicating device is a light-emitting diode (LED).

**Revendications**

1. Indicateur de l'état de décharge pour une batterie (B) comportant une bobine de réactance (L) et un premier transisteur (T1) en série à la batterie de telle façon que la base du premier transisteur (T1) soit abordée périodiquement, avec un consommateur (R, M), alimenté par la batterie (B) et avec un dispositif indicateur (LED) branché parallèlement à la ligne collecteur-émetteur du premier transisteur (T1), <u>caracté-risé en ce que,</u>

    a) entre la base du premier transisteur (T1) et l'un des pôles (–) de la batterie (B) est disposé un deuxième transisteur (T2), sont la base est polarisée d'une part et qui grâce à un premier condensateur (C1) en dépendance du courant circulant à travers de la bobine (L) est influencé de telle manière d'autre part que la disposition se mette en oscillation en cas de descente de la tension de la batterie (UB) au dessous d'une valeur déterminée et que le dispositif indicateur réagisse donc,

    b) à l'un des pôles (–) de la batterie (B), derrière le point de jonction de la ligne du courant principal du deuxième transisteur (T2) un interrupteur (S) est prévu qui

        b1) met en circuit le courant par le consommateur (R, M),

        b2) met en circuit le courant par la bobine (L) et

        b3) qui met en marche le dispositif par l'abordement d'un troisième transisteur (T3) situé entre l'autre pôle (+) de la batterie(B) et la ligne du courant principal du deuxième transisteur (T2).

2. Indicateur de l'état de décharge suivant la revendication 1, <u>caractérisé en ce que</u> la base du deuxième transisteur (T2) est polarisée via la ligne du courant principal du troisième transisteur (T3) grâce à un diviseur de tension (R4, R5) disposé parallèlement à la batterie (B), et que la base du premier transisteur (T1) est connectée via une première résistance (R2) à l'autre pôle (+) de la batterie (B) et que le premier condensateur (C1) est disposé entre la base du deuxième transisteur (T2) et le point de jonction (A) de la bobine (L) avec le premier transisteur (T1).

3. Indicateur de l'état de décharge suivant l'une quelconque des revendications 1 et 2 <u>caractérisé en ce que</u> un deuxième condensateur (C2) est monté parallèlement à la ligne-émetteur-base du deuxième transisteur (T2).

4. Indicateur de l'état de décharge suivant l'une quelconque des revendications susmentionnées <u>caractérisé en ce que</u> en série au premier condensateur (C1) une deuxième resistance (R10) est montée en série.

5. Indicateur de l'état de décharge suivant l'une quelconque des revendications susmentionnées <u>caractérisé en ce que</u> la résistance de la base (R5) du deuxième transisteur (T2) consiste du circuit en série de deux résistances (R6, R7), montées parallèlement, et d'une troisième résistance (R8), une des résistances (R7) montée parallèlement étant caractérisée en tant que résistance NCT pour l'adaption à la différence de la température de la batterie (B).

6. Indicateur de l'état de décharge suivant l'une quelconque des revendications susmentionnées pour le cas où le consommateur soit une charge inductive, p. ex. un moteur (M), <u>caractérisé en ce que</u> parallèlement à la ligne-collecteur-émetteur du deuxième transisteur (T2) est branché un quatrième transisteur (T4) dont la base est branchée via une quatrième résistance (R9) au point de jonction d'un troisième condensateur (C3) et à une diode (D1), mis en circuit en série au consommateur.

7. Indicateur de l'état de décharge suivant l'une quelconque des revendications susmentionnées <u>caractérisé en ce que</u> le dispostif indicateur est une diode de luminance (LED).

FIG.1

FIG.2